## Europäisches Patentamt

## European Patent Office

## Office européen des brevets

(11) Publication number: **0 047 090**
**B1**

(12) **EUROPEAN PATENT SPECIFICATION**

(45) Date of publication of patent specification: **27.12.85**

(21) Application number: **81303721.5**

(22) Date of filing: **14.08.81**

(51) Int. Cl.⁴: **H 03 M 1/12**

(54) Method of and apparatus for converting an analogue voltage to a digital representation.

(30) Priority: **01.09.80 GB 8028186**

(43) Date of publication of application:
**10.03.82 Bulletin 82/10**

(45) Publication of the grant of the patent:
**27.12.85 Bulletin 85/52**

(84) Designated Contracting States:
**AT BE CH DE FR IT LI LU NL SE**

(56) References cited:
**FR-A-2 204 083**
**GB-A-1 158 877**
**GB-A-1 192 734**
**US-A-3 879 724**
**US-A-4 149 256**

**RADIO-ELECTRONICA, vol. 19, no. 1, 1st
January 1971, pages 13-14, Deventer (NL);
C.MUSQUETIER: "A/D converter met slechts 4
bits voor 10/00 resolutie"
ELEKTRONIK, no. 10, January 1960, pages
291-297, Muchen (DE); L.STARKE: "Digital-
Voltmeter- eine Ubersicht"**

(73) Proprietor: **SOUTH EASTERN ELECTRICITY
BOARD
Queen's Gardens Hove
Sussex BN3 2LS (GB)**

(72) Inventor: **Fielden, John Spensley
Homeville
Ottery St. Mary Devon (GB)**

(74) Representative: **Mayes, Stuart David et al
BOULT, WADE & TENNANT 27 Furnival Street
London, EC4A 1PQ (GB)**

Courier Press, Leamington Spa, England.

## Description

This invention relates to apparatus for and methods of converting an input analogue voltage into a digital representation.

It is well-known to change an analogue voltage to a digital representation by utilising a voltage divider to divide a known reference voltage into a number of equal intervals and then to compare the unknown input analogue voltage with the various steps on the divider output to detect when the input voltage is equal to one of the steps of the divided reference voltage.

With such an arrangement, the analogue-to-digital conversion is carried out with a resolution which is equal to the number of steps in the voltage divider. There is thus a limit to the resolution which can be achieved.

The potential divider, from a practical point of view, also may put a limit on the accuracy with which the conversion can be achieved. Thus, if there are 200 divisions, any 100 units must equal (within 1 unit) any other 100 units to give 1% accuracy. It is thus difficult and expensive to implement an accurate analogue-to-digital conversion of more than say 256 divisions.

It is known from Radio-Electronica, vol. 19, No. 1, 1st January 1971, pages 13—14 and from Elektronik, No. 10, January 1960, pages 291—297 to provide interpolation between the successive coarse steps by using a fine stepped or staircase voltage. Such arrangements not only bring in extra problems in defining accurately and correctly the fine steps but they also assume that the main divider steps are necessarily equal and accurate.

It is an object of the present invention to provide an improved method of and apparatus for analogue-to-digital conversion which will enable resolution to be effected within the steps by a linear interpolation. As will be further apparent, it is possible with the method and apparatus of the present invention to improve the effective accuracy by reducing the effect of non-linearity of the steps of the divider.

According to one aspect of the present invention a method of converting an input analogue voltage to a digital output signal comprising the steps of applying a first fixed reference voltage to a potential divider having N stages each of 1 unit, and comparing the magnitude of the input voltage with the divider outputs to determine the magnitude of the input analogue voltage by the number of the unit step of the divider defining one limit of the unit range containing the magnitude of said input analogue voltage and wherein a time-varying voltage is combined with the input analogue voltage, a comparison being made between the combined voltage and the divider output to determine also the fraction of the voltage within a unit of voltage step defined by one stage of the divider output is characterised in that the time-varying voltage is a ramp voltage changing in magnitude by a number, greater than unity, of said units of voltage step of the divider output, the combined ramp and input voltage being repetitively compared with the divider output to determine the number $Q_0$ defining an integral number of unit steps and the repetitive determinations of the number of unit steps found by the successive comparisons during the ramping being averaged to determine also the fraction of the plurality of unit steps over which the time-varying voltage is ramped, this fraction representing the difference between the actual magnitude $Q$ of the input voltage and $Q_0$, said fraction of said plurality of unit steps being determined from the fraction of the period of ramping over said plurality of unit steps which is taken for the combined voltage to reach the magnitude of one of said divider outputs, and wherein an output is provided in digital form by combining $Q_0$ and said fraction of said plurality of unit steps.

In explaining this method, it is convenient to consider a simple case. The comparison is first effected using successive steps of the divider output to determine the two successive steps between which the unknown voltage lies. Assume now that the divider setting is left at one of these steps. Suppose the unknown voltage lies one quarter of the way between the magnitude of step $Q_0$ and the next higher step $Q_1$. If one then adds a linear ramp voltage to the unknown voltage, with the ramp starting at zero and taking $n$ comparison periods to increase by a magnitude corresponding to one step of the divider output, then the successive comparisons, assuming that the output number read from the converter is the lower limit of the unit range, will be at the magnitude $Q_0$ for $\frac{3}{4}n$ comparison and will be at the magnitude $Q_1$ (equals $Q_0+1$) for the next $n/4$ comparisons. By simple counting of the number of comparisons between the start of the comparisons and the time when $Q_1$ is first reached (that is to say $\frac{3}{4}n$) will give the fractional part to be interpolated in obtaining the more accurate resolution.

It will be readily apparent however that the ramp need not start at zero provided it starts from some known level. It is convenient therefore to start the comparison and counting procedure when the ramp reaches a value $P_0$ corresponding to some step of the divider output. In this case, the comparison values will be $Q_0+P_0$ for $\frac{3}{4}n$ comparisons and $Q_1$ and $P_0$ for the remaining $\frac{1}{4}n$ comparisons if the comparison operation is continued for $n$ comparisons. The ramp rate however may be predetermined so that the number $n$ is known and the comparison need only be continued for the $\frac{3}{4}n$ comparisons.

By using a linear ramp, the fraction of the ramp cycle corresponds to the fraction of the ramp voltage change. Moreover this fraction can be determined digitally by counting the number of comparisons made during a ramping period before equality with $Q_0$ is obtained and comparing this with the total number of comparison periods in the ramp cycle.

It will be seen that, by this technique, increased resolution is obtained by interpolation between the steps of the output of the potential divider. The ramp voltage in the present invention continues over more than one step of the divider output. By doing this, the interpolation is no longer dependent on the exact accuracy of one particular step of the divider output but is related to the average accuracy of a number of steps.

As explained later, it is convenient to make comparisons alternately with the divider outputs of the ramp voltage and the combined ramp and unkown voltage and, for this purpose, switching means may be provided for alternately applying the ramp voltage and the combined voltage to a comparator. The switching means constitutes a sampling device sampling successive voltage values. The successive values of the voltage will differ. It is convenient to refer to these successively applied voltages as samples.

Suppose for example that the ramp continues for four steps up to levels $P_1$, $P_2$, $P_3$ and $P_4$ of voltage from the divider after a magnitude $P_0$ which corresponds to one of the steps. Assume, as before, that there are $n$ samples in each step of the combined ramp and unknown voltage. If the fractional value of the input voltage is one quarter of the way between $Q_0$ and $Q_1$, the above technique will result in the counting of $\frac{3}{4}n$ samples of $(Q_0+P_0)$, then the counting of $n$ samples of $(Q_0+P_1)$, then the counting of $n$ samples of $(Q_0+P_2)$ and lastly the counting of $n/4$ samples of $(Q_0+P_3)$. There is a total of $4n$ counts. If these $4n$ count values are summed and averaged, it will be seen that the required magnitude is determined by subtracting the appropriate total magnitude of the ramp from the average. If the magnitudes of $P_0$, $P_1$, $P_2$ etc. differed by exactly one unit, this gives the same results as using a ramp over one unit. If the magnitudes $P_0$, $P_1$, $P_2$ etc. do not differ by exactly one unit, improved accuracy is obtained by summing and averaging not over $n$ counts but by averaging all the count samples and by subtracting the appropriate value of the ramp from the sum. Mathematically this is equivalent to averaging all the count values, subtracting 0 so long as the ramp is assumed to be between $P_0$ and $P_1$, subtracting one from each count value so long as the ramp is assumed to be between $P_1$ and $P_2$ and so on, and finally averaging and subtracting $P_0$ from the average. It will be seen that the required magnitude is determined but that the accuracy is no longer dependent on the voltage accuracy of one step of the divider output but depends on the average accuracy of a number of steps. It will be noted that $Q_0$ need not be the nearest step to $Q$ as long as the ramping takes the voltage across the value of $Q$. The fraction determined may therefore be greater than unity. Preferably however the fraction is kept to a value less than unity by appropriate choice of the starting point.

It will thus be seen that the method of the present inventin not only enables the resolution of an analogue-to-digital converter to be increased beyond the resolution determined by the number of steps in the potential divider by making use of linear interpolation between the steps. If the potential divider is highly accurate, then the increased resolution gives increased accuracy. However, as explained above, by making use of a ramp voltage extending over several unit stages of the divider output, effectively tolerances in the size of the divider stages can be averaged out. Thus, if 64 digits are used for the ramp, then the overall linearity will be 64 times better than if only one digit were used. The ramping over a number of digits reduces the magnitude of the full scale reading. If the divider had 256 units of output and it was required to ramp over 64 digits, then the full scale reading would have a maximum range of 192 units. In practice however if the divider had 256 units, not more than 16 digits of resolution would be necessary and one might take 256 samples over a ramp of 16 units. This would give sufficiently accurate results to guarantee a one in sixteen thousand resolutions for any practical eight-bit converter.

It will be seen therefore that the present invention enables both increased resolution and, by reducing linearity problems, increased accuracy to be obtained, provided sufficient time is available to effect the measurement. As indicated above, 256 samples might be required. Typically, with present-day equipment this might be achieved in a time of the order of 1 second.

Although in the above explanation it has been assumed that the voltage ramp is an upwards ramp, this is not necessary. The ramping may be upwards or downwards or ramps may be alternately upwards and downwards. The rate of ramping must be sufficiently slow to permit of the necessary sampling to be effected whilst obtaining the desired number of steps for the interpolation. For the conversion of direct voltages or very slowly varying voltages, this does not present any problem. For measurements of voltage of alternating supplies, pulse sampling synchronised with the alternating waveform may be employed. If the waveform is assumed to be sinusoidal, since a summing and averaging technique is employed, it is possible to use a plurality of samples in each cycle. Typically using the above-described technique for measuring a voltage at 50 Hz, it would take about 1 second for the analogue-to-digital conversion to be effected.

The invention furthermore includes within its scope an apparatus for converting an input analogue voltage to a digital output signal comprising a potential divider having N equal stages, means for applying a first fixed reference voltage to said potential divider to provide N+1 comparison outputs at equal intervals from 0 to N units, means for generating a time-varying reference voltage, means for adding said time-varying reference voltage to the input analogue voltage and applying the combined voltage to a comparator for comparing the combined reference and input voltage with the divider outputs and to determine the number defining an integral number of unit steps, which number represents one limit of a unit range containing said analogue voltage, and also to determine, from the fraction of the time-varying reference voltage required for the combined voltage to reach the magnitude of one of said divider outputs, the fraction of a unit representing the difference between the actual magnitude of the input analogue voltage and the magnitude of the potential of one of the divider outputs characterised in that the means generating the time-varying reference voltage is a ramp voltage generator with an output changing in magnitude by a number, greater than unity, of unit steps of the divider output and in that the comparator means is arranged repetitively and regularly to compare the combined voltage with the divider outputs to determine the number $Q_0$ defining the integral number of steps, and to average the results of the comparisons to determine the fractional part of a step and in that output means are provided for indicating in digital form the combined magnitude of $Q_0$ and said fraction.

The ramp voltage may generate a ramp voltage starting from a known magnitude and there may be provided means for applying the ramp voltage to said comparator and means operative to initiate the repetitive sampling when the ramp voltage reaches a magnitude $P_0$ corresponding to one step of the divider output.

For the reasons previously described, if the sampling is over a period in which the ramp voltage changes by more than one unit step, then the advantages of averaging over the sizes of the different steps (to improve accuracy) can be obtained by sampling the ramp voltage alone as well as the combined ramp and unknown voltage at regular intervals so that the computation assumes that the changes in unit steps occur after each "$n$" samples rather than using the actual step of magnitude. Therefore preferably means are provided for sampling the ramp voltage at regular intervals between the sampling of the combined ramp and unknown voltage and comparing the sampled ramp voltage with the potential divider outputs to determine when the last required step change in ramp voltage is complete. The apparatus may then include a microprocessor having means for counting the total number of samples over the whole ramping period, means for summing the digital magnitudes of all the samples over a period when the ramp changes from $P_0$ to $(P_0+m)$ units, where $m$ is an integer greater than unity, means for correcting the sum for the counted unit steps in the ramp voltage, and means for dividing the corrected accumulated sum by the number of samples taken and subtracting $P_0$ from the result to provide the required digital output.

Switching means may be provided for selectively applying either the ramp voltage or the combined ramp and unknown voltage to the comparator. The microprocessor may be arranged to operate the switching means so that the two comparisons are made alternately and counting means may be provided to count the number of sample determination from the time when the ramp voltage is at magnitude $P_0$ to the time when the combined voltage reaches one step of the divider output. The counting can then continue until the ramp voltage reaches $P_0+m$ digits. The microprocessor may be arranged to sum all the readings indicating the magnitude of the combined voltage during this period, to average these readings by dividing the sum by the number of samples taken and then to subtract $P_0$.

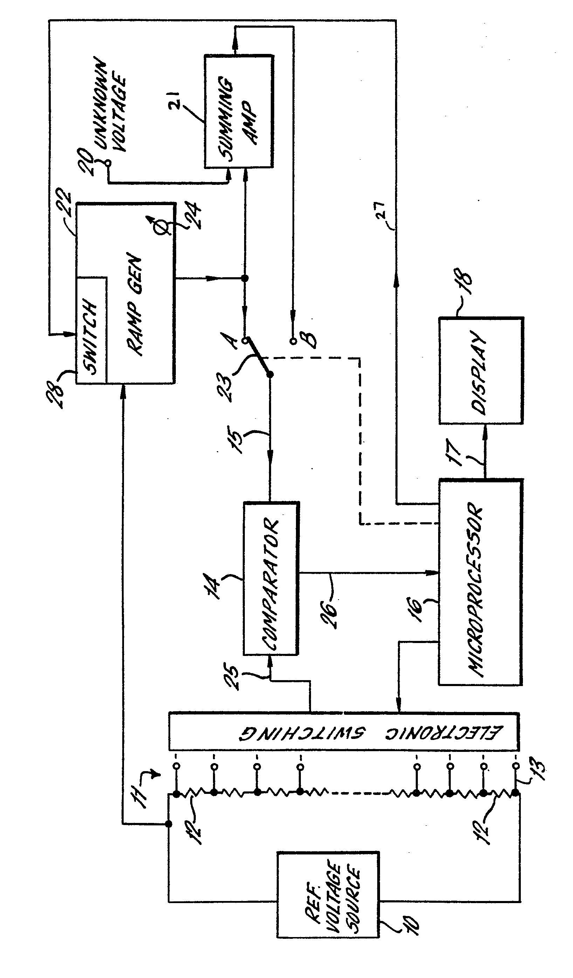

The accompanying drawing is a diagram illustrating one construction of analogue-to-digital converter constituting one embodiment of the invention.

Referring to the drawing there is shown a stabilised voltage source 10 applying a stable known voltage to a potential divider 11 comprising 256 units 12 and with taps 13 between the resistors and the end of the chain giving thereby 256 taps providing known voltage outputs with respect to one end of the chain. These reference voltage steps are utilised for comparison, in a comparator 14, with a voltage on a line 15.

The switching of the taps 10 to the comparator is controlled by a microprocessor 16. The switching of the taps is at a sufficiently slow speed to permit of a large number of comparisons to be made during the period each successive tap is selected, as will be explained in further detail later. The switching control is effected by counting the appropriate number of comparison periods and then operating the switch. Conveniently an electronic switching unit 19 is employed.

The microprocessor 16, in response to the output from the comparator 14, provides a digital output representation at 17 representing the magnitude of the analogue voltage on the lead 15 by determining the step Q defining one limit of the unit range containing the magnitude of the input voltage. The digital representation at output 17 may be applied to an indicator 18 or may be utilised in other ways, e.g. in digital data processing apparatus. The construction thus far described, apart from the slower speed of switching, operates in a manner similar to a conventional analogue-to-digital converter and, with present-day microprocessors, it is possible to make a comparison with each of 256 tapped reference voltages and obtain a reading of a magnitude Q say every 40 micro-seconds.

In the following description it is assumed that the voltage to be measured is a sinusoidal or substantially sinusoidal voltage waveform having a frequency of 50 Hz. Synchronised sampling is employed with four samples in each cycle of the waveform. Because an averaging technique is employed, it is possible to measure an alternating voltage in this way, provided the samples are taken at predetermined sample points synchronised with the alternating waveform.

In the embodiment shown in the accompanying drawing, the unknown voltage to be converted is applied to a terminal 20 forming one input of a summing amplifier 21 having a second input from a ramp voltage generator 22 which generates a linear ramp voltage extending over slightly more than 16 units of output of the divider in a time of slightly less than one second. This is the time period required to obtain the appropriate number of samples using synchronised sampling of an alternating waveform. The input 15 of the comparator 14 is connected by a switch 23 to one or other of two terminals A and B. The switch 23 is controlled by the microprocessor 16 in a manner to be described later. The terminal A is connected to the output of the ramp generator 22 whilst the terminal B is connected to the output of the summing unit 21.

The comparator has a second input 25 which is connected by the aforementioned switching unit 19 sequentially to the selected taps 13 on the voltage divider 11. The comparator thus compares the voltage on the selected tap with the sum of the unknown voltage and the ramp voltage. When equality is reached, the comparator provides an output at 26 to the microprocessor.

In measuring an alternating waveform, an offset voltage of known magnitude is added to the unkown to ensure that the samples are all of the same polarity. This offset is provided by the ramp generator. Because of the slow rate of ramping required for measurement purposes, provision is made for the ramp generator to ramp very quickly to the offset voltage before it starts the slow ramp. The offset voltage is conveniently the voltage halfway along the divider. The rapid ramp is therefore readily controlled by repetitive comparison, at a fast rate, of the rapidly changing ramp voltage with the divider outputs and stopping the fast ramp when it has reached step number 129. The slow ramp is then initiated. The required offset is thus obtained inherently from the divider output by control of the ramp generator 22 from the microprocessor 16, as indicated at 27, the ramp generator having a switch 28 operated to initiate a slow ramp when the switching sequence of switching unit 19 reaches the appropriate step, as indicated by a signal on lead 26.

As will be apparent from the following description, the ramping may be upwards or downwards or may be alternately upwards and downward. In explaining the construction however it is convenient to assume that the voltage is ramping upwards. The switch 23 is put in the position A and readings are taken of the magnitude P determined by the comparator and microprocessor. These readings P are indicative of one limit of the step range which embraces the instantaneous magnitude of the ramp voltage at the time the sample is made. These readings are made frequently e.g. every 60 or 100 microseconds and, in this particular embodiment, this is done while the voltage is slowly ramping upwardly. Eventually the ramp voltage will pass one division of the divider network and the magnitude of the measured output will change. This value is taken as the datum value $P_0$. The switch 23 is then placed in position B and the reading $Q_1$ of the combined unknown and ramp voltage is noted in the microprocessor 16. The switch is switched back to position A and a reading taken of the magnitude of the ramp voltage. The voltage is ramping slowly and this reading will still be $P_0$ for the first sample taken. The reading is compared with the previously noted value $P_0$ and, if there is no change, the switch is then put back into position B and a second reading $Q_2$ of the magnitude of Q is obtained and, in the microprocessor 16, is added to the first reading to give a total $Q_1+Q_2$. This process is continued determining alternately P and Q until eventually the value of P suddenly changes from $P_0$ to $P_0$ plus one digit. It would at this point be possible to determine the value of Q by dividing the accumulated sum $Q_1+Q_2+ \ldots .Q_n$ by the number $n$ of samples taken and subtracting $P_0$. The value obtained in this way is a linear interpolation between two steps of the divider output. Suppose the unknown voltage was, for example, one quarter of the way up from one step to the next, then the first three quarters of the $n$ samples would give the same value $Q_0$ whilst for $Q_1$, $Q_2$ etc. the last quarter $n$ samples would have the value $(Q_0+1)$. By taking a large number of samples, any desired resolution can be obtained.

In the particular embodiment being described, the ramping continues upwardly for 64 unit steps beyond the magnitude $P_0$. To permit of this, the magnitude of the unknown voltage must be less than 192 unit steps so as to permit comparisons to be made with the potential divider output when the maximum ramp voltage is added. The averaging is effected over the whole number of samples. 256 samples are taken over the whole range of the ramp voltage. It is convenient to make provision, indicated diagrammatically at 24, for adjusting the ramp rate so that the time taken to change by a unit step is the time taken for making $n$ sample determinations. The sampling rate is controlled by the microprocessor 16.

The measured values of all the samples of combined ramp and unknown voltage (i.e. the divider step numbers noted from the comparison) are summed. The sum is corrected by one unit for each sample measured when the ramp voltage is assumed to lie between one and two units above $P_0$, deducting two units for each sample when the measured ramp voltage assumed to lie between two and three units above $P_0$ and so on. The corrected sum is divided by the total number of samples and $P_0$ is deducted to obtain thereby the magnitude of the unknown voltage. This computation is effected in the microprocessor 16. It will be readily apparent that the various steps of the computation may mathematically be effected in a different order.

If the unknown voltage is a direct voltage, or a voltage which changes only very slowly, then there is adequate time to effect the necessary measurements. As has been explained, the device described however can readily be used for making measurements of the voltage of an alternating mains supply, e.g. at a frequency of say 50 Hz, by synchronizing the operation of the microprocessor with the mains supply frequency.

**Claims**

1. A method of converting an input analogue voltage to a digital output signal comprising the steps of applying a first fixed reference voltage to a potential divider having N stages each of 1 unit, and comparing the magnitude of the input voltage with the divider outputs to determine the magnitude of the input analogue voltage by the number of the unit step of the divider defining one limit of the unit range containing the magnitude of said input analogue voltage and wherein a time-varying voltage is combined with the input analogue voltage, a comparison being made between the combined voltage and the divider output to determine also the fraction of the voltage within a unit of voltage step defined by one stage of the divider output, characterised in that the time-varying voltage is a ramp voltage changing in magnitude by a number, greater than unity, of said units of voltage step of the divider output, the combined ramp and input voltage being repetitively compared with the divider output to determine the number $Q_0$ defining an integral number of unit steps and the repetitive determinations of the number of unit steps found by the successive comparisons during the ramping being averaged to determine also the fraction of the plurality of unit steps over which the time-varying voltage is ramped, this fraction representing the difference between the actual magnitude $Q$ of the input voltage and $Q_0$, said fraction of said plurality of unit steps being determined from the fraction of the period of ramping over said plurality of unit steps which is taken for the combined voltage to reach the magnitude of one of said divider outputs, and wherein an output is provided in digital form by combining $Q_0$ and said fraction of said plurality of unit steps.

2. A method as claimed in claim 1 characterised in that the ramp rate is adjusted so that a predetermined number of comparisons are made whilst the ramp voltage changes by an integral number of unit steps.

3. A method as claimed in claim 2 characterised in that the number of comparisons is counted between the time when the ramp voltage is at a known magnitude $P_0$ to the time when the magnitude of the unknown plus the ramp is detected as changing to a preselected step in the divider output.

4. A method as claimed in any of the preceding claims characterised in that the comparison and counting procedure is started when the ramp voltage reaches a value $P_0$ corresponding to some step on the divider output.

5. A method as claimed in claim 4 characterised in that the comparison is continual until the ramp reaches a value corresponding to a predetermined integral number of steps from $P_0$.

6. A method as claimed in any of the preceding claims characterised in that the digital magnitude determined by each comparison is summed and the sum averaged over a number of comparisons in which the ramp voltage changes by an integral number of steps greater than unity.

7. A method as claimed in any of the preceding claims characterised in that the ramp voltage ramps upwardly.

8. A method as claimed in any of claims 1 to 6 characterised in that the ramp voltage ramps downwardly.

9. A method as claimed in any of claims 1 to 6 characterised in that the ramp voltage ramps alternately upwardly and downwardly.

10. An apparatus for converting an input analogue voltage to a digital output signal comprising a potential divider (11) having N equal stages (12), means (10) for applying a first fixed reference voltage to said potential divider to provide (N+1) comparison outputs (13) at equal intervals from 0 to N units, means (22) for generating a time-varying reference voltage, means (21) for adding said time-varying reference voltage to the input analogue voltage and applying the combined voltage to a comparator means (14, 16, 26) for comparing the combined reference and input voltage with the divider outputs and to determine the number defining an integral number of unit steps, which number represents one limit of a unit range containing said analogue voltage, and also to determine, from the fraction of the time-varying reference voltage required for the combined voltage to reach the magnitude of one of said divider outputs, the fraction of a unit representing the difference between the actual magnitude of the input analogue voltage and the magnitude of the potential of one of the divider outputs, characterised in that the means generating the time-varying reference voltage is a ramp voltage generator (22) with an output changing in magnitude by a number, greater than unity, of unit steps of the divider output and in that the comparator means (14, 16, 26) is arranged repetitively and regularly to compare the combined voltage with the divider outputs to determine the number $Q_0$ defining the integral number of steps, and to average the results of the comparisons to determine the fractional part of a step and in that output means (18) are provided for indicating in digital form the combined magnitude of $Q_0$ and said fraction.

11. Apparatus as claimed in claim 10 characterised in that said ramp voltage generator (22) generates a ramp voltage starting from a known magnitude and in that there are provided means (23) for applying the ramp voltage to said comparator (14) and means (16) operative to initiate repetitive comparison by said comparator when the ramp voltage reaches a magnitude $P_0$

corresponding to one step of the divider output (13).

12. Apparatus as claimed in either claim 10 or claim 11 characterised in that switching means (23) are provided for selectively applying either the ramp voltage or the combined ramp and unknown voltage to the comparator (14).

13. Apparatus as claimed in claim 12 characterised in that said switching means is arranged for alternately sampling and applying to the comparator the ramp voltage and the combined ramp and the unknown voltage and in that the comparator (14) is arranged to compare the sampled ramp voltage with the potential divider outputs (13) to determine when the successive step changes in ramp voltage occur and in that there is provided a microprocessor (16) having means for counting the number of samples over the various successive periods for changes of one step in the ramp voltage, means for summing the digitised magnitudes of all the samples of the combined ramp and unknown voltage over a period when the ramp changes from $P_0$ to $(P_0+m)$ units, means for correcting the sum for the counted unit steps in the sampled ramp voltage and means for dividing the corrected accumulated sum by the number of samples of the combined ramp and unknown voltage taken and subtracting $P_0$ from the result to provide the required digital output.

14. Apparatus as claimed in any of claims 10 to 13 characterised in that means (24) are provided for adjusting the ramp rate so that the ramp voltage changes by a predetermined number of unit steps of the divider output in a predetermined number of sampling cycles.

15. Apparatus as claimed in either claim 12 or claim 13 characterised in that a microprocessor (16) is arranged to operate the switching means (23) so that the two comparisons are made alternately and in that counting means (16) are provided arranged to count the number of sample determinations of the combined ramp and unknown voltage from the time when the ramp voltage is at magnitude $P_0$ to the time when the combined voltage reaches one step of the divider output.

16. Apparatus as claimed in claim 15 characterised in that the counting means (16) are arranged to continue counting until the ramp voltage reaches $(P_0+m)$ digits and in that, to average the digital determinations, the microprocessor (16) is arranged to sum all the determinations of integral digital values indicating the magnitude of the combined voltage during this period and to average these determinations by dividing the sum by the number of samples of the combined ramp and unknown voltage taken and then to subtract $P_0$.

**Patentansprüche**

1. Verfahren zum Umwandeln einer analogen Eingangsspannung in ein digitales Ausgangssignal mit folgenden Verfahrensschritten:

eine erste feste Referenzspannung wird an einen Spannungsteiler mit N Stufen angelegt, die jeweils einer Einheit entsprechen,

die Größe der Eingagangsspannung wird mit den Spannungsteilerausgangssignalen verglichen und durch die Nummer desjenigen Spannungseinheitsschritts des Spannungsteilers bestimmt, der eine Grenze desjenigen Einheitsbereichs festlegt, innerhalb dessen die Größe des genannten analogen Eingangsspannung liegt,

eine zeitveränderliche Spannung wird mit der analogen Eingangsspannung kombiniert,

zur Bestimmung auch des Bruchteils der Spannung innerhalb eines durch eine Stufe des Spannungsteilerausgangssignals definierten Spannungseinheitsschritts wird die kombinierte Spannung mit dem Spannungsteilerausgangssignal verglichen, dadurch gekennzeichnet,

daß die zeitveränderliche Spannung eine Rampenspannung ist, die ihre Größe um mehr als einen der genannten Spannungseinheitsschritte des Spannungsteilerausgangssignals ändert,

daß die Kombination aus Rampenspannung und Eingangsspannung wiederholt mit dem Spannungsteilerausgangssignal verglichen wird, um die Zahl $Q_0$ zu bestimmen, die eine ganzzahlige Anzahl von Spannungseinheitsschritten definiert,

daß die weiderhilten Ermittlungen der Zahl der Spannungseinheitsschritte, die durch die aufeinanderfolgenden Vergleiche während der Äderung der Rampenspannung erfaßt werden, einer Mittelwertbildung unterworfen werden, um auch den Bruchteil der Mehrzahl von Spannungseinheitsschritten zu ermitteln, über die die zeitveränderliche Spannung sich hinwegbewegt, wobei dieser Bruchteil die Differenz zwischen der tatsächlichen Größe Q der Eingangsspannung und $Q_0$ darstellt,

daß der genannte Bruchteil der Mehrzahl von Spannungseinheitsschritten aus dem Bruchteil der Zeitspanne bestimmt wird, in der die Rampenspannung sich über die genannte Mehrzahl von Spannungseinheitsschritten hinwegbewegt, bis die kombinierte Spannung die Größe eines der Spannungsteilerausgangssignale erreicht,

und daß durch die Kombination von $Q_0$ und dem genannten Bruchteil des Anzahl von Spannungseinheitsschritten das digitale Ausgangssignal erzeugt wird.

2. Verfahen nach Anspruch 1, dadurch gekennzeichnet, daß die Geschwindigkeit, mit der die Rampenspannung sich ändert, so bemessen ist, daß eine vorbestimmte Anzahl von Vergleichen durchgeführt wird, während die Rampenspannung sich um eine ganzzahlige Anzahl von Spannungseinheitsschritten ändert.

3. Verfahren nach Anspruch 2, dadurch gekennzeichnet, daß die Anzahl der Vergleiche abgezählt wird, die durchgeführt werden zwischen dem Zeitpunkt, in dem die Rampenspannung eine bekannte Größe $Q_0$ hat, und dem Zeitpunkt, in dem festgestellt wird, daß die Summe aus der unbekannten Spannung und der Rampenspannung zu einem vorgewählten Schritt des Spannungsteilerausgangssignals wechselt.

4. Verfahren nach einem der vorhergehenden Ansprüche, dadurch gekennzeichnet, daß die Vergleichs- und Zählprozedur beginnt, wenn die Rampenspannung einen Wert $P_0$ erreicht, der einem Spannungseinheitsschritt des Spannungsteilerausgangssignals entspricht.

5. Verfahren nach Anspruch 4, dadurch gekennzeichnet, daß der Vergleich fortgesetzt wird, bis die Rampenspannung eine vorbestimmte ganzzahlige Anzahl von Spannungseinheitsschritten von $P_0$ entfernt ist.

6. Verfahren nach einem der vorhergehenden Ansprüche, dadurch gekennzeichnet, daß die bei den einzelnen Vergleichen ermittelten digitalen Größen summiert werden und die Summe über eine Anzahl von Vergleichen einer Mittelwertbildung unterzogen wird, während der die Rampenspannung sich um eine ganzzahlige Anzahl von Spannungseinheitsschritten ändert, die größer ist also eins.

7. Verfahren nach einem der vorhergehenden Ansprüche, dadurch gekennzeichnet, daß die Rampenspannung eine ansteigende Spannung ist.

8. Verfahren nach einem der Ansprüche 1 bis 6, dadurch gekennzeichnet, daß die Rampenspannung eine abfallende Spannung ist.

9. Verfahren nach einem der Ansprüche 1 bis 6, dadurch gekennzeichnet, daß die Rampenspannung alternierend ansteigt und abfällt.

10. Gerät zur Umwandlung einer analogen Eingangsspannung in ein digitales Ausgangssignal

mit einem Spannungsteiler (11) mit N gleichen Stufen (12),

mit Mitteln (10) zum Anlegen einer ersten festen Referenzspannung an den Spannungsteiler und zur Erzeugung von (N+1) Vergleichsausgangssignalen (13) mit gleichen Intervallen von Null bis N Einheiten,

mit Mitteln (22) zur Erzeugung einer zeitveränderlichen Referenzspannung,

mit Mitteln (21) zum Addieren dieser zeitveränderlichen Referenzspannung zu der analogen Eingangsspannung und zum Anlegen der kombinierten Spannung an eine Komparatoreinrichtung (14, 16, 26), um die kombinierte Referenz- und Eingangsspannung mit den Spannungsteilerausgangssignalen zu vergleichen und die Zahl zu bestimmen, die eine ganzzahlige Anzahl von Spannungseinheitsschritten kennzeichnet, die eine Grenze eines die genannte analoge Spannung enthaltenden Einheitsbereichs repräsentiert, und um aus dem Bruchteil der zeitveränderlichen Referenzspannung, der notwendig ist, damit die kombinierte Spannung die Größe eines der Spannungsteilerausgangssignale erreicht, den Bruchteil einer Einheit zu bestimmen, der die Differenz zwischen der tatsächlichen Größe der analogen Eingangsspannung und der Größe der Spannung eines der Spannungsteilerausgangssignale repräsentiert, dadurch gekennzeichnet,

daß die Mittel zur Erzeugung der zeitveränderlichen Referenzspannung ein Rampenspannungsgenerator (20) sind, dessen Ausgangssignal seine Größe um eine Anzahl von Spannungseinheitsschritten des Spannungsteilerausgangssignals ändert, die größer ist als eins,

daß die Komparatoreinrichtung (14, 16, 26) derart ausgebildet ist, daß sie die kombinierte Spannung wiederholt und regelmäßig mit den Spannungsteilerausgangssignalen vergleicht, um die Zahl $Q_0$ zu ermitteln, welche die ganzzahlige Anzahl von Spannungseinheitsschritten definiert, und die Ergebnisse der Vergleiche einer Mittelwertbildung zu unterziehen, um den Bruchteil eines Spannungseinheitsschrittes zu bestimmten,

und daß eine Ausgabeeinrichtung (18) zur Anzeige der kombinierten Größe von $Q_0$ und des genannten Bruchteils in digitaler Form vorgesehen ist.

11. Gerät nach Anspruch 10, dadurch gekennzeichnet, daß der Rampenspannungsgenerator (22) eine Rampenspannung erzeugt, die bei einer bekannten Größe beginnt, und daß Mittel (23) zum Anlegen der Rampenspannungen an den Komparator (14) sowie Mittel (16) vorgesehen sind, die bewirken, daß der Komparator zur Durchführung wiederholter Vergleiche initiiert wird, wenn die Rampenspannung eine Größe $P_0$ erreicht, die einen Spannungseinheitsschritt des Spannungsteilerausgangssignals (13) entspricht.

12. Gerät nach Anspruch 10 oder 11, dadurch gekennzeichnet, daß Schaltmittel (23) vorgesehen sind, durch die selektiv entweder die Rampenspannung oder die Kombination aus Rampenspannung und unbekannter Spannung an den Komparator (14) anlegbar ist.

13. Gerät nach Anspruch 12, dadurch gekennzeichnet,

daß die Schaltmittel so angeordnet sind, daß sie alternierend abtasten und dem Komparator abwechselnd die Rampenspannung und die Kombination von Rampenspannung und unbekannter Spannung zuführen,

daß der Komparator (14) so angeordnet ist, daß er die abgestastete Rampenspannung mit den Spannungsteilerausgangssignalen (13) vergleicht, um festzustellen, wann die aufeinanderfolgenden Schrittänderungen in der Rampenspannung stattfinden,

und daß ein Mikroprozessor (16) vorgesehen ist, der

—Mittel zum Abzählen der Anzahl der Abtastproben über die verschiedenen aufeinanderfolgenden Perioden, in denen sich die Rampenspannung jeweils um einen Schritt ändert,

—Mittel zum Summieren der digitalisierten Größen aller Abtastproben der Kombination aus Rampenspannung und unbekannter Spannung über eine Periode, wenn die Rampenspannung von $P_0$ auf $(P_{0+1})$ Einheiten wechselt,

—Mittel zum Korrigieren der Summe der angezählten Spannungseinheitsschritte in der abgetasteten Rampenspannung,

—sowie Mittel zum Dividieren der korrigierten akkumulierten Summe durch die Zahl der gewonnenen Abtastproben der Kombination aus Rampenspannung und unbekannter Spannung und zum Subtrahieren des Werts $P_0$ von dem Ergebnis und damit zur Erzeugung des geforderten digitalen Ausgangssignals aufweist.

14. Gerät nach einem der Ansprüche 10 bis 13, dadurch gekennzeichnet, daß Mittel (24) vorgesehen sind, durch die die Änderungsgeschwindigkeit der Rampenspannung derart einstellbar ist, daß diese sich während einer vorbestimmten Anzahl von Abtastzyklen um eine vorbestimmte Anzahl von Spannungseinheitsschritten des Spannungsteilerausgangssignals ändert.

15. Gerät nach Anspruch 12 oder 13, dadurch gekennzeichnet, daß der Mikroprozessor so angeordnet ist, daß er die Schaltmittel (23) in der Weise betätigt, daß die beiden Vergleiche alternierend durchgeführt werden, und die Zählmittel (16) vorgesehen sind, die die Anzahl der Abtastprobenbestimmungen der Kombination aus Rampenspannung und unbekannter Spannung von dem Zeitpunkt, in welchem die Rampenspannung die Größe $P_0$ hat, bis zu dem Zeitpunkt zählen, in dem die Kombination aus Rampenspannung und unbekannter Spannung einen Spannungseinheitsschritt des Spannungsteilerausgangssignals erreicht.

16. Gerät nach Anspruch 15, dadurch gekennzeichnet, daß die Zählmittel (16) den Zählvorgang fortsetzen, bis die Rampenspannung $(P_0+m)$ Schritte erreicht und daß der Mikroprozessor (16) zur Mittelwertbildung der digitalen Abtastproben ganzzahliger digitaler Werte, die der Größe der kombinierten Spannung während dieser Periode summieren und ihren Mittelwert bilden, indem sie die Summe durch die Anzahl der Abtastproben der aus Rampenspannung und unbekannter Spannung kombinierten Spannung teilen und dann $P_0$ subtrahieren.

## Revendications

1. Procédé de conversion d'une tension analogique d'entrée en un signal numérique de sortie, comprenant les étapes d'application d'une première tension fixe de référence à un diviseur de potentiel ayant N étages d'une unité chacun, et de comparaison de l'amplitude de la tension d'entrée aux signaux de sortie du diviseur afin que l'amplitude de la tension analogique d'entrée soit déterminée par le nombre de pas d'un unité du diviseur formant une limite de la plage unitaire contenant l'amplitude de la tension analogique d'entrée, et dans lequel une tension variant au cours du temps est combinée à la tension analogique d'entrée, une comparaison étant effectuée entre la tension combinée et le signal de sortie du diviseur afin que la fraction de tension comprise dans un pas d'une unité de tension délimité par un palier du signal de sortie du diviseur soit aussi déterminée, caractérisé en ce que la tension variant au cours du temps est une tension variant progressivement dont l'amplitude varie d'un nombre, supérieur à un, d'unités de pas de tension du signal de sortie du diviseur, la combinaison des tensions variant progressivement et d'entrée étant comparée de façon répétée au signal de sortie du diviseur afin que le nombre $Q_0$ qui définit un nombre entier de pas unitaires soit déterminé, les déterminations répétées du nombre de pas unitaires determinés par les comparaisons successives pendant la variation progressive étant soumises à une opération de moyenne qui détermine aussi la fraction de l'ensemble des pas unitaires sur lesquels la tension variant au cours du temps varie progressivement, cette fraction représentant la différence entre l'amplitude réelle Q de la tension d'entrée et $Q_0$, la fraction de l'ensemble de pas unitaires étant déterminée d'après la fraction de la période de variation progressive sur l'ensemble des pas unitaires qui est nécessaire pour que la tension combinée atteigne l'amplitude de l'un des signaux de sortie du diviseur, et dans lequel un signal de sortie est transmis sous forme numérique par combinaison de $Q_0$ avec ladite fraction de l'ensemble des pas unitaires.

2. Procédé selon la revendication 1, caractérisé en ce que la vitesse de variation progressive est réglée de manière qu'un nombre prédéterminé de comparaisons soit réalisé pendant que la tension variant progressivement varie d'un nombre entier de pas unitaires.

3. Procédé selon la revendication 2, caractérisé en ce que le nombre de comparaisons est compté entre le moment où la tension variant progressivement a une amplitude connue $P_0$ et le moment où l'amplitude de la tension inconnue augmentée de la tension variant progressivement est detectée comme passant à un palier préalablement choisi dans le signal de sortie du diviseur.

4. Procédé selon l'une quelconque des revendications précédentes, caractérisé en ce que la procédure de comparaison et de comptage commence lorsque la tension variant progressivement atteint une valeur $P_0$ correspondant à un certain palier du signal de sortie du diviseur.

5. Procédé selon la revendication 4, caractérisé en ce que la comparaison est continue jusqu'à ce que la tension variant progressivement atteigne une valeur correspondant à un nombre entier prédéterminé de pas à partir de $P_0$.

6. Procédé selon l'une quelconque des revendications précédentes, caractérisé en ce que les amplitudes numériques déterminées par toutes les comparaisons sont additionnées, et la somme est mise sous forme d'une moyenne sur un certain nombre de comparaisons dans lequel la tension variant progressivement change d'un nombre entier de pas, supérieur à un.

7. Procédé selon l'une quelconque des revendications précédentes, caractérisé en ce que la tension variant progressivement augmente.

8. Procédé selon l'une quelconque des revendications 1 à 6, caractérisé en ce que la tension variant progressivement diminue.

9. Procédé selon l'une quelconque des revendications 1 à 6, caractérisé en ce que la tension variant progressivement augmente et diminue alternativement.

10. Appareil de conversion d'une tension analogique d'entrée en un signal numérique de sortie, comprenant un diviseur de potentiel (11) ayant N étages égaux (12), un dispositif (10) destiné à appliquer une première tension fixe de référence au diviseur de potentiel afin qu'il forme (N+1) sorties de comparaison (13) à intervalles égaux de 0 à N unités, un dispositif (22) générateur d'une tension de référence variant au cours du temps, un dispositif (21) destiné à ajouter la tension de référence variant au cours du temps à la tension analogique d'entrée, à appliquer la tension combinée à un comparateur (14, 16, 26) destiné à comparer la combinaison des tension combinées de référence et d'entrée aux signaux de sortie du diviseur et à déterminer le nombre déterminant un nombre entier de pas unitaires, ce nombre représentant une limite d'une plage unitaire contenant la tension analogique, et destiné aussi à déterminer, à partir de la fraction de la tension de référence variant au cours du temps nécessaire pour que la tension combinée atteigne l'amplitude de l'un des signaux de sortie du diviseur, la fraction d'une unité représentant la différence entre l'amplitude réelle de la tension analogique d'entrée et l'amplitude du potentiel de l'un des signaux de sortie du diviseur, caractérisé en ce que le dispositif générateur d'une tension de référence variant au cours du temps est un générateur (22) d'une tension variant progressivement ayant un signal de sortie dont l'amplitude varie d'un certain nombre, supérieure à un, de pas unitaires du signal de sortie du diviseur, et en ce que le comparateur (14, 16, 26) est réalisé de manière qu'il assure de façon répétée et régulière la comparaison de la tension combinée aux signaux de sortie du diviseur et détermine ainsi le nombre $Q_0$ déterminant le nombre entier de pas, et la formation de la moyenne des résultats des comparaisons afin qu'il détermine la partie fractionnaire d'un pas, et en ce qu'un dispositif de sortie (18) est incorporé afin qu'in indique, sous forme numérique, l'amplitude combinée de $Q_0$ et de ladite fraction.

11. Appareil selon la revendication 10, caractérisé en ce que le générateur (22) d'une tension variant progressivement crée une tension variant progerssivement à partir d'un amplitude connue, et en ce qu'il comporte un dispositif (23) destiné à appliquer la tension variant progressivement au comparateur (14) et un dispositif (16) destiné à déclencher la comparaison répétée par le comparateur lorsque la tension variant progressivement atteint une amplitude $P_0$ correspondant à un palier du signal de sortie du diviseur (13).

12. Appareil selon l'une des revendications 10 et 11, caractérisé en ce qu'un dispositif (23) de commutation est destiné à appliquer sélectivement soit la tension variant progressivement soit la tension combinée inconnue et variant progressivement au comparateur (14).

13. Appareil selon la revendication 12, caractérisé en ce que le dispositif de commutation est réalisé de manière qu'il assure en alternance l'échantillonnage et l'application au comparateur de la tension variant progressivement et de la combinaison des tension variant progressivement et inconnue, et en ce que le comparateur (14) est réalisé de manière qu'il compare la tension échantillonnée variant progressivement avec les signaux de sortie (13) du diviseur de potentiel et détermine les moments où les changements successifs de paliers de la tension variant progressivement ont lieu, et en ce qu'il comporte un microprocesseur (16) ayant un dispositif de comptage du nombre d'échantillons prélevés dans les diverses périodes successives correspondant à des changements d'un pas de la tension variant progressivement, un dispositif destiné à additionner les amplitudes numérisées de tous les échantillons de la combinaison des tension variant progressivement et inconnue pendant une période dans laquelle la tension variant progressivement passe de $P_0$ à $(P_0+m)$ unités, un dispositif destiné à corriger la somme des pas unitaires comptés dans la tension échantillonnée variant progressivement, et un dispositif destiné à diviser la somme cumulée corrigée par le nombre d'échantillons de la combinaison des tension variants progressivement et inconnue qui ont été prélevés et à soustraire $P_0$ du résultat afin qu'il forme le signal numérique nécessaire de sortie.

14. Appareil selon l'une quelconque des revendications 10 à 13, caractérisé en ce qu'il comporte un dispositif (24) destiné à régler la vitesse de variation progressive afin que la tension variant progressivement change d'un nombre prédéterminé de pas unitaires du signal de sortie du diviseur pendant un nombre prédéterminé de cycles d'échantillonnage.

15. Appareil selon l'une des revendications 12 et 13, caractérisé en ce qu'un microprocesseur (16) est destiné à commander le dispositif de commutation (23) afin que les deux comparaisons soient exécutées an alternance, et en ce qu'il comporte un dispositif de comptage (16) disposé afin qu'il compte le nombre de déterminations d'échantillons de la combinaison des tensions variant progressivement et inconnues à partir du moment où la tension variant progressivement a une amplitude $P_0$ et jusqu'au moment où la tension combinée atteint un palier du signal de sortie du diviseur.

16. Appareil selon la revendication 15, caractérisé en ce que le dispositif de comptage (16) est réalisée afin qu'il continue à compter jusqu'à ce que la tension variant progressivement atteigne $(P_0+m)$ chiffres et en ce que, afin que les déterminations numériques soient moyennées, le microprocesseur (16) est réalisé de manière qu'il additionne toutes les déterminations des valeurs numériques entières indiquant l'amplitude de la tension combinée pendant cette période et qu'il forme la moyenne de ces déterminations par division de la somme par le nombre d'échantillons prélevés de la combinaison des tensions variant progressivement et inconnue, puisqu'il soustrait $P_0$.

SUMMING AMP 21

UNKNOWN VOLTAGE 20

RAMP GEN 22

SWITCH 28

24 Ø

A 23

B

15

27

COMPARATOR 14

25

26

16

MICROPROCESSOR

17

DISPLAY 18

ELECTRONIC SWITCHING

11

12

12

13

REF. VOLTAGE SOURCE 10

1